Europäisches Patentamt

European Patent Office

Office européen des brevets

(11) Veröffentlichungsnummer: **0 267 499 B1**

(12) **EUROPÄISCHE PATENTSCHRIFT**

(45) Veröffentlichungstag der Patentschrift: **24.07.91**

(51) Int. Cl.⁵: **H03M 13/00, G06F 11/00**

(21) Anmeldenummer: **87115925.7**

(22) Anmeldetag: **29.10.87**

(54) **Verfahren zur Paritätsbitermittlung und zur Überwachung der Übertragung beim Datenschieben sowie Schaltungsanordnung zur Durchführung der Verfahren.**

(30) Priorität: **31.10.86 DE 3637149**

(43) Veröffentlichungstag der Anmeldung:
**18.05.88 Patentblatt 88/20**

(45) Bekanntmachung des Hinweises auf die
Patenterteilung:
**24.07.91 Patentblatt 91/30**

(84) Benannte Vertragsstaaten:
**AT BE CH DE FR GB IT LI NL SE**

(56) Entgegenhaltungen:
**DE-A- 2 100 887**
**US-A- 3 751 646**
**US-A- 4 107 649**
**US-A- 4 556 978**

**PATENT ABSTRACTS OF JAPAN, Band 3, Nr.
145 (E-155), 30. November 1979, Seite 156 E
155; & JP-A-54 124 947.**

**PATENT ABSTRACTS OF JAPAN, Band 5, Nr.
1, (P-43)[673], 8. Januar 1981; & JP-A-55 134
455.**

(73) Patentinhaber: **Siemens Aktiengesellschaft**
**Wittelsbacherplatz 2**
**W-8000 München 2(DE)**

(72) Erfinder: **Birkhäuser, Jürgen, Dipl.-Phys.**
**Albert-Schweitzer-Strasse 50**
**W-8000 München 83(DE)**

**Beschreibung**

Verfahren zur Paritätsbitermittlung beim Datenschieben und zer Überwachung der Übertragung von während der Übertragung Datenverschiebungen unterworfenen Daten in Datenverarbeitungsanlagen, sowie Schaltungsanordnung zur Durchführung der Verfahren.

Die Erfindung betrifft ein Verfahren zur Paritätsbitermittlung beim Datenschieben und zur Überwachung der Übertragung von während der Übertragung Datenverschiebungen unterworfenen Daten in Datenverarbeitungsanlagen, sowie eine Schaltungsanordnung zur Durchführung des Verfahrens entsprechend den Merkmalen des Oberbegriffes des Patentanspruches 1.

Eine der häufigsten Methoden zur Fehlerüberwachung von Einfachfehlern in Datenverarbeitungsanlagen ist die Paritätsbitprüfung. Dabei wird zum Beispiel den die Daten bildenden Dateneinheiten mit je n Bitstellen ein eigenes, auf gerades oder ungerade Anzahl von Einsen oder Nullen ergänzendes Paritätsbit beigeordnet, das vor der Weiterverarbeitung der Dateneinheit bzw. am Schluß einer Übertragungsstrecke mit dem bei einer Paritätsbitkontrolle gewonnenen Paritätsbit verglichen wird. Bei Übereinstimmung der beiden Paritätsbits wird dann davon ausgegangen, daß seit der letzten Paritätsbitkontrolle kein Fehler aufgetreten ist und die Daten der Dateneinheit unverfälscht vorliegen.

Durchlaufen die Daten logische oder arithmetische Operationen ausführende Funktionseinheiten, kann die nachfolgende Paritätsbitsicherung in der Regel nicht mehr anhand der alten Paritätsbits der ursprünglichen Dateneinheiten durchgeführt werden. Zum Beispiel gehen bei Datenverschiebungen um ungleich acht Bitstellen mit bytegroßen Dateneinheiten die Byteparitäten verloren. Die pro Byte mitgelieferten Paritätsbits der ursprünglichen Dateneinheiten besitzen nach dem Schiebevorgang keinerlei Aussagekraft bezüglich der Byteparität der neuen Dateneinheiten mehr. Für die weitere Datenübertragung müssen deshalb neue Paritätsbits generiert werden. Durch die im Anschluß an den Verschiebevorgang erfolgende Paritätsbitneugenerierung wird aber die Arbeitsgeschwindigkeit einer Datenverarbeitungsanlage herabgesetzt.

Die nachträglich zu einem Verschiebevoregang ausgeführte Paritätsbitneugenerierung wirkt sich insbesondere bei der Überwachung der Übertragung von während der Übertragung Datenverschiebungen unterworfenen Daten nachteilig aus. Wegen der Paritätsbitneugenerierung anhand der nach dem Schieben neu entstandenen Daten können vor der die Datenverschiebung bewirkenden Datenverschiebeeinrichtung oder durch den Schiebevorgang verfälschte Daten nicht mehr erkannt werden. Bisher ist deshalb zum einen vor einem Datenschieber eine Paritätsbitkontrolle notwendig, bei der festgestellt wird, ob dem Datenschieber überhaupt richtige Daten angeliefert werden, und zum anderen wird zur Überwachung des Datenschiebers dieser wenigstens zweimal parallel mit jeweils einem eigenen nachfolgenden Paritätsbitgenerator aufgebaut. In einer den einzelnen Paritätsbitgeneratoren nachgeschalteten Stufe werden dann durch einen Vergleicher die von den einzelnen Paritätsbitgeneratoren ermittelten Paritätsbits miteinander verglichen, wobei eine Abweichung zu einer Fehlermeldung führt. Erst nach diesen Maßnahmen ist mittels Paritätsbitsicherung eine überwachte Übertragung von Daten auf einem Leitungsabschnitt mit Datenschiebern wieder gewährleistet.

Diese Methode der Absicherung eines Leitungsabschnittes mit Datenschiebern benötigt einen großen Hardwareaufwand, besonders dann, wenn im gleichen Leitungsabschnitt mehrere Datenschieber in Reihe vorhanden sind. Mehrere seriell geschaltetete Datenschieber sind zum Beispiel dann möglich, wenn ein Datenschieber die Dateneinheiten stellenweise und ein zweiter die Dateneinheiten insgesamt verschiebt, um Schiebeamplituden größer als die Anzahl der Bitstellen einer Dateneinheit zu verwirklichen. In diesen Fall ist vor jedem einzelnen Datenschieber eine Paritätsbitkontrolle notwendig, sowie jeweils dazugehöriger nachfolgender Logik zur Paritätsbitneugenerierung. Hinzu kommt die Hardware für die Vergleichslogik zum Vergleichen der gewonnenen einzelnen Paritätsbits.

Eine andere Möglichkeit, die korrekte Funktion des Datenschiebers zu überwachen, ist in US-A-4 556 978 beschrieben. Sie besteht darin, aus den verschobenen Ausgangsdaten und der Schiebeamplitude die Parität der Eingangsdaten zurückzuberechnen und mit der ursprünglichen Paritätsinformation zu vergleichen. Dabei steht jedoch die neue Paritätsinformation nach der Verschiebung nicht zur Verfügung.

Selbst wenn auf die Überwachung des Datenschiebers verzichtet wird, muß wenigstens für die Paritätsbitkontrolle vor einem Datenschieber und für die Paritätsbitneugenerierung nach einem Datenschieber über die Zeit für den eigentlichen Schiebevorgang hinaus zusätzliche Zeit aufgewendet werden. Dadurch wird die Arbeitsgeschwindigkeit einer Datenverarbeitungsanlage herabgesetzt. Der Zeitfaktor wirkt sich wie der Hardwareaufwand um so mehr aus, je mehr Datenschieber in einem Leitungsabschnitt hintereinander geschaltet sind.

Aufgabe der Erfindung ist daher ein Verfahren zur Bildung der Paritätsbits der Dateneinheiten von in Dateneinheiten unterteilten Daten beim Verschieben der Daten durch Datenverschiebeeinrichtungen in Datenverarbeitungsanlagen, durch das neben der Zeit für die Paritätsberechnung während des Schiebevorganges keine zusätzliche Zeit für eine nachträglich ausgeführte Paritätsbitermittlung benötigt und die Überwachung von Übertragungen mit Datenverschiebungen vereinfacht wird, sowie eine Schaltungsanordnung zur Durchführung des Verfahrens.

Diese Aufgabe wird hinsichtlich des Verfahrens gemäß der Erfindung durch die Merkmale des kennzeichnenden Teiles des Patentanspruches 1 gelöst. Die Erfindung nutzt dabei die Tatsache, daß Paritätsbits von Datenteilen durch eine EXKLUSIV-ODER-Verknüpfung zu einem Paritätsbit für die Gesamtheit der Datenteile zusammengefaßt werden können und das neue Paritätsbit einer verschobenen Dateneinheit aus dem ursprünglichen Paritätsbit in Verbindung mit den Paritätsbits für die von der jeweiligen Dateneinheit abgegebenen und aufgenommenen Datenbits ableitbar ist. Die Paritätsbits der aus einer Dateneinheit herausgeschobenen und der in eine Dateneinheit hineingeschobenen Datenbits können bereits ab dem Zeitpunkt des Vorliegens der Schiebeamplitude aus den noch unverschobenen Dateneinheiten berechnet werden. Zusammen mit dem ursprünglichen Paritätsbit einer Dateneinheit kann damit für jede Dateneinheit das Paritätsbit der nach dem Schieben vorliegenden Dateneinheit parallel zum Ablauf des Schiebevorganges ermittelt werden. Die nachträglich zum Verschiebevorgang ausgeführte Paritätsbitermittlung, die einen Zeitverlust und damit eine Herabsetzung der Arbeitsgeschwindigkeit einer Datenverarbeitungsanlage verursacht, entfällt dadurch. Da für die Ermittlung selbst nur einfache logische Bausteine benötigt werden, die im Vergleich zum Datenschieber wesentlich schneller sind, steht mit dem Ende des Schiebevorganges praktisch gleichzeitig jeweils das neue Paritätsbit der Dateneinheiten fest.

Wird der die Daten um höchstens n-1 Bitstellen verschiebenden Datenverschiebeeinrichtung eine Datenverschiebeeinrichtung, die die Daten um die größtmögliche Anzahl ganzer Dateneinheiten verschiebt, vorangestellt bzw. nachgeschaltet, sind beliebige paritätsbegleitende Datenverschiebungen, auch solche um mehr Bitstellen als eine Dateineinheit Bitstellen aufweist, unter Verwendung des Verfahrens gemäß der Erfindung möglich.

Werden die infolge einer nichtzyklischen Verschiebung freiwerdenden Bitstellen mit einem konstanten Wert wie zum Beispiel "Null" aufgefüllt, und bei den bei Datenverschiebungen um ganze Dateneinheiten vollständig geräumten Dateneinheiten ein entsprechendes Paritätsbit eingesetzt, sind des weiteren auch nicht zyklische paritätsbegleitende Datenverschiebungen durchführbar.

In einer vorteilhaften Weiterbildung der Erfindung ist es nicht notwendig, für jede Dateneinheit das Paritätsbit der in die Dateneinheit hineingeschobenen Datenbits und das Paritätsbit der aus der Dateneinheit herausgeschobenen Datenbits zu bestimmen, da das Paritätsbit der aus der Dateneinheit herausgeschobenen Datenbits jeweils identisch ist mit dem Paritätsbit der in die nachfolgende Dateneinheit hineingeschobenen Datenbits. Es genügt, wenn bei mehrere Dateneinheiten umfassenden Daten jeweils entweder nur das Paritätsbit der in eine Dateneinheit hineingeschobenen oder nur das Paritätsbit der aus einer Dateneinheit herausgeschobenen Datenbits ermittelt wird. Zur Berechnung des Paritätsbits einer neuen Dateneinheit kann das fehlende Paritätsbit direkt von der Vorgängerdateneinheit bzw. Nachfolgerdateneinheit übernommen werden. Damit wird eine weitere Hardwareeinsparung erzielt.

Das Verfahren gemäß der Erfindung ist gleichzeitig die Voraussetzung für die Überwachung der Übertragung von während der Übertragung Datenverschiebungen unterworfenen Daten durch eine einzige, erst am Ende der Übertragungsstrecke erforderliche Paritätsbitkontrolle gemäß Anspruch 5, weil danach das zu jeder verschobenen Dateneinheit gehörende neue Paritätsbit in Abhängigkeit von dem der ursprünglichen Dateneinheit zugrundeliegenden Paritätsbit gebildet wird. Das heißt, tritt zum Beispiel vor der Datenschiebeeinrichtung ein durch ein nicht zur Dateneinheit passendes Paritätsbit gekennzeichneter Fehler auf, so wird diese Kennzeichnung durch die Ermittlung des neuen Paritätsbits gemäß der Erfindung nicht zerstört. Eine Paritätsbitkontrolle zur der Datenschiebeeinrichtung zur Überwachung des der Datenschiebeeinrichtung vorangehenden Leitungsabschnittes erübrigt sich damit, da sie durch die den gesamten Leitungsabschnitt überwachende abschließende Paritätsbitkontrolle mit überwacht wird. Tritt beim Verschieben einer Dateneinheit ein Fehler auf, ist durch die oben erwähnte Abhängigkeit die Wechselbeziehung zwischen Paritätsbit und Dateneinheit nachfolgend ebenfalls bleibend gestört. Die gestörte Wechselbeziehung kann deshalb wieder mit der dem gesamten Leitungsabschnitt überwachenden abschließenden Paritätsbitkontrolle erfaßt werden. Damit entfällt eine Vervielfachung der Datenschiebeeinrichtung zu ihrer Überwachung ebenso wie die jeweils ihnen nachfolgenden Paritätsbitgeneratoren mit der dazugehörigen Vergleichslogik zum Vergleich der Einzelergebnisse.

Die Schaltungsanordnung gemäß der Erfindung ergibt sich aus Anspruch 6. Sie ist parallel zur Datenschiebeeinrichtung angeordnet und bezieht ihre sämtlichen zur Ermittlung der jeweils neuen Paritätsbits für die einzelnen verschobenen Dateneinheiten notwendigen Informationen von deren Eingängen. Die Paritätsbitermittlung kann deshalb gleichzeitig mit dem Schiebevorgang der Daten in der Datenschiebeeinrichtung erfolgen, wodurch der zeitliche Gewinn erzielt wird.

Die Schaltungsanordnung weist je Dateneinheit zwei Auswahleinrichtungen auf, von denen jeweils abhängig vom Ausmaß der durch die Schiebeamplitude festgelegten Verschiebung die eine von der zugehörigen Dateneinheit herauszuschiebende und die andere von der in Datenschieberichtung vorangehenden Dateneinheit die in die zugehörige Dateneinheit hineinzuschiebende Datenbits gleichzeitig auswählt. Die ausgewählten Datenbits werden in jeweils nachfolgenden Auswerteeinrichtungen zu einem Paritätsbit der in die zugehörige Dateneinheit hineingeschobenen und zu einem Paritätsbit der aus der zugehörigen Dateneinheit herausgeschobenen Datenbits zusammengefaßt. Die Zusammenfassung geschieht hierbei durch einfache EXKLUSIV-ODER-Glieder in der an sich bei der Paritätsbitermittlung zweier Datenkomponenten bekannten Weise, daß nämlich jeweils einzelne Bitstellen der Datenkomponenter paarweise zusammengefaßt werden. Die durch die Auswerteeinrichtungen erhaltenen Paritätsbits schließlich bilden nach weiteren EXKLUSIV-ODER-Verknüpfungen zusammen mit dem alten Paritätsbit der ursprünglichen Dateneinheit das neue Paritätsbit der verschobenen Dateneinheit.

In einer vorteilhaften Weiterbildung der Erfindung entfällt eine Auswahleinrichtung einschließlich der ihr nachgeschalteten Auswerteeinrichtung, wodurch weniger Hardware benötigt wird. Das von der verbleibenden Auswahleinrichtung gebildete Paritätsbit ist gleichzeitig für die benachbarte Dateneinheit das dort nicht gebildete Paritätsbit. Dieses gilt sowohl für die, das Paritätsbit aus den aus den Dateneinheiten herausgeschobenen, als auch für die, das Paritätsbit aus den in die Dateneinheiten hineingeschobenen Datenbits bildende Auswahleinrichtung. Die jeweils gebildeten Paritätsbits werden lediglich entweder der jeweiligen Vorgänger- oder jeweiligen Nachfolgerdateneinheit zugeführt. Damit stehen für alle Dateneinheiten sämtliche zur Ermittlung des neuen Paritätsbits einer verschobenen Dateneinheit notwendigen Paritätsbits zur Verfügung.

Zum Ausführen von Datenverschiebungen um mehr Bitstellen, als eine Dateneinheit Bitstellen aufweist, wird der die Dateneinheiten um einzelne Bitstellen verschiebenden Datenverschiebeeinrichtung eine um ganze Dateneinheiten unter Beibehaltung der Zuordnung von Paritätsbit und Dateneinheit verschiebende Datenverschiebeeinrichtung entweder vor- oder nachgeschaltet, wobei die um einzelne Bitstellen verschiebende Verschiebeeinrichtung die Dateneinheiten dann nur noch um die restliche, nicht mehr die Anzahl der Bitstellen einer Dateneinheit erreichende Anzahl von Bitstellen verschiebt.

Einzelheiten der Erfindung seien nachfolgend anhand eines in der Zeichnung dargestellten Ausführungsbeispieles näher erläutert. Im einzelnen zeigen

FIG 1 ein Übersichtsschaltbild für eine Datenschiebeeinrichtung mit der die Ergebnisparitätsbits liefernden Schaltungsanordnung.

FIG 2 ein Blockschaltbild der die Ergebnisparitätsbits liefernden Schaltungsanordnung von FIG 1,

FIG 3 ein Blockschaltbild einer gegenüber der von FIG 2 vereinfachten Schaltungsanordnung und

FIG 4 ein Schaltbild der in FIG 2 und FIG 3 verwendeten Auswahlschalteinrichtungen.

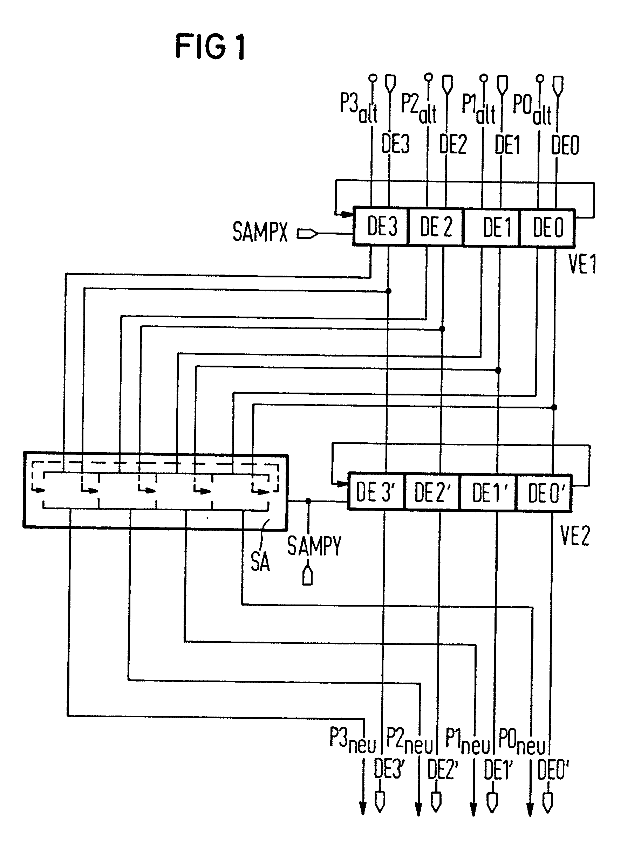

Mit dem in FIG 1 gezeigten Ausführungsbeispiel können Daten mit je vier gleichgroßen Dateneinheiten DE3 bis DE0 zyklisch nach rechts um eine beliebige Anzahl von Bitstellen verschoben werden. Die einzelnen Dateneinheiten DE3 bis DE0 umfassen dabei jeweils acht einzelne Datenbitstellen $DE_8$ bis $DE_1$, die ihrerseits jeweils mit einem eigenen Paritätsbit $P_{alt}$ gesichert sind.

Das Übersichtsschaltbild weist zwei Verschiebeeinrichtungen VE1 und VE2, sowie eine Schaltungsanordnung SA auf, die die Paritätsbits $P3_{neu}$ bis $PO_{neu}$ der durch das Verschieben neu entstehenden Dateneinheiten DE3' bis DE0' ermittelt. Die von der Schaltungsanordnung SA pro Dateneinheit DE neu ermittelten Paritätsbits $P3_{neu}$ bis $PO_{neu}$ werden für die weitere Datenübertragung den entsprechenden neu entstandenen Dateneinheiten DE3' bis DE0' hinzugefügt. Sie ersetzen damit die den ursprünglichen Dateneinheiten DE3 bis DE0 hinzugefügten alten Paritätsbits $P3_{alt}$ bis $PO_{alt}$.

Die Verschiebeeinrichtung VE1 führt abhängig von der Schiebeamplitude SAMPX eine zyklische Datenverschiebung der Dateneinheiten DE3 bis DE0 nach rechts um eine Dateneinheit bis zu drei Dateneinheiten durch. Die den jeweiligen Dateneinheiten anfänglich zugeordneten alten Paritätsbits $P_{alt}$ werden dabei um die gleiche Anzahl ganzer Dateneinheiten nach rechts verschoben, so daß die jeweilige Zuordnung der alten Paritätsbits $P_{alt}$ zu den ursprünglichen Dateneinheiten erhalten bleibt.

In der zweiten Verschiebeeinrichtung VE2 werden Datenverschiebungen nach rechts um die restliche Anzahl von Bitstellen ausgeführt, die nicht mehr eine Verschiebung um eine ganze Dateneinheit ergeben. Während dieses Verschiebevorganges entstehen die neuen Dateneinheiten DE3' bis DE0'. Die Schiebeamplitude wird durch das Steuersignal SAMPY festgelegt. Die Rückkopplung bewirkt wie bei der Verschiebeeinrichtung VE1 einen zyklischen Verschiebevorgang. Die neuen Dateneinheiten DE3' bis DE0' können an Parallelausgän-

gen der Verschiebeeinrichtung VE2 abgegriffen werden.

Zur Bildung der neuen, bei der Verschiebung um die restlichen Bitstellen entstehenden Paritätsbits $P_{neu}$ in der Verschiebeeinrichtung VE2, ist dieser die Schaltungsanordnung SA parallelgeschaltet. Sie erhält gleichzeitig mit der Verschiebeeinrichtung VE2 die Dateneinheiten DE3 bis DE0 und darüber hinaus die alten, den einzelnen Dateneinheiten zugeordneten Paritätsbits $P_{alt}$. Ferner erhält die Schaltungsanordnung SA gleichzeitig mit der Verschiebeeinrichtung VE2 über das Steuersignal SAMPY die Schiebeamplitude. Mittels dieser Informationen bildet sie während des Schiebens der Dateneinheiten in der Verschiebeeinrichtung VE2 die neuen zu den verschobenen Dateneinheiten DE3' bis DE0' gehörenden Paritätsbits $P3_{neu}$ bis $P0_{neu}$.

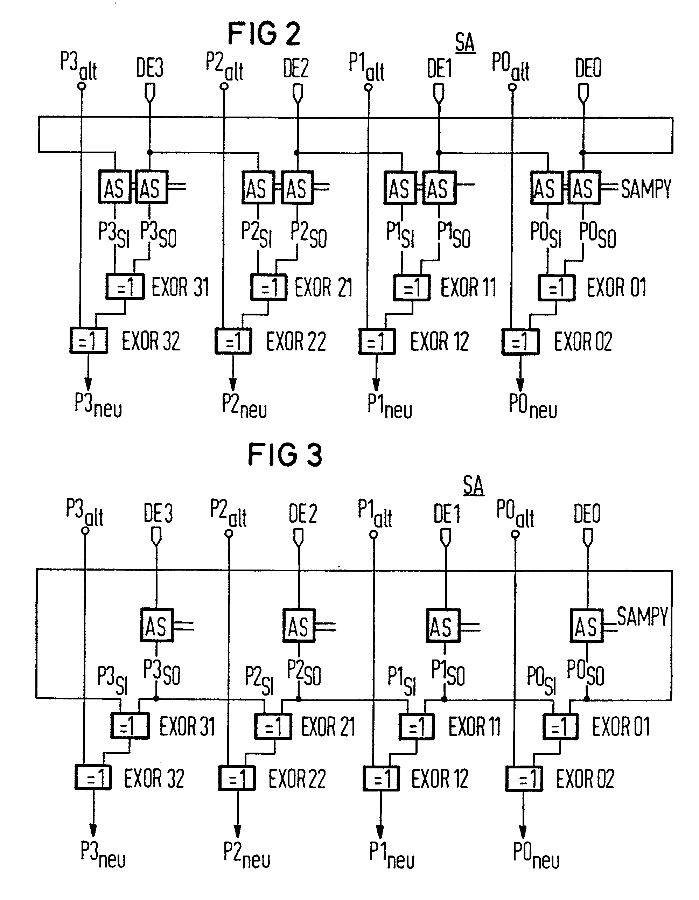

Das Blockschaltbild von FIG 2 zeigt ein Ausführungsbeispiel der Schaltungsanordnung SA in FIG 1. Entsprechend der Anzahl der zu verarbeitenden Dateneinheiter DE3 bis DE0 ist sie in vier Grundschaltungen unterteilt. Diese einzelnen Grundschaltungen ermitteln jeweils für eine der Dateneinheiten DE3 bis DE0 die zu den nach dem Verschieben neu entstehenden Dateneinheiten DE3' bis DE0' entsprechend gehörenden neuen Paritätsbits $P3_{neu}$ bis $PC_{neu}$. Die Ermittlung der neuen Paritätsbits $P3_{neu}$ bis $P0_{neu}$ erfolgt nach der Beziehung

$$P_{neu} = P_{alt} \# P_{SI} \# P_{SO'}$$

wobei $P_{SI}$ das Paritätsbit der in eine Dateneinheit hineingeschobener Datenbits und $P_{SO}$ das Paritätsbit der aus dieser Dateneinheit herausgeschobenen Datenbits, $P_{alt}$ das der vor der Verschiebung um die restlichen Bitstellen ursprünglichen Dateneinheit zugeordnete und $P_{neu}$ das der nach der Verschiebung um die restlichen Bitstellen neu entstehenden Dateneinheit zugehörige Paritätsbit angibt.

Die Verknüpfung der Paritätsbits $P_{SI}$, $P_{SO}$ und $P_{alt}$ erfolgt mit jeweils zwei EXKLUSIV-ODER-Gliedern EXOR31/EXOR32 bis EXOR01/EXOR02. Das Paritätsbit $P_{SO}$ wird jeweils mit einer von der Schiebeamplitude SAMPY gesteuerten Auswahlschaltung AS ermittelt. Am Eingang dieser Auswahlschaltung AS wird dazu jeweils die noch nicht um die restlichen Bitstellen verschobene Dateneinheit DE angelegt.

Die Ermittlung des Paritätsbits $P_{SI}$ erfolgt mittels einer zweiten Auswahlschaltung AS, der die jeweilige Vorgängerdateneinheit zugeführt wird. Durch die jeweilige Zuordnung der Vorgängerdateneinheit ergibt sich die Rückleitung vom Eingang der das Paritätsbit $P_{SO}$ der Dateneinheit DE0 ermittelnden Auswahlschaltung AS zum Eingang der das Paritätsbit $P_{SI}$ der Dateneinheit DE3 ermittelnden Auswahlschaltung AS.

Das Ausführungsbeispiel von FIG 3 unterscheidet sich von dem gemäß FIG 2 dadurch, daß je Grundschaltung nur eine Auswahlschaltung AS verwendet wird, indem das Paritätsbit $P_{SO}$ gleichzeitig das Paritätsbit $P_{SI}$ für die jeweilige Nachfolgerdateneinheit bildet. Damit entfällt pro Dateneinheit die für die Ermittlung des Paritätsbits $P_{SI}$ benutzte Auswahlschaltung AS. In diesem Fall ergibt sich eine Rückleitung vom Ausgang der, das Paritätsbit $PO_{SO}$ der Dateneinheit DE0 ermittelnden Auswahlschaltung AS zu einem Eingang, der die Paritätsbits $P3_{SI}$ und $P3_{SO}$ der Dateneinheit DE3 zusammenfassenden EXKLUSIV-ODER-Stufe EXOR31.

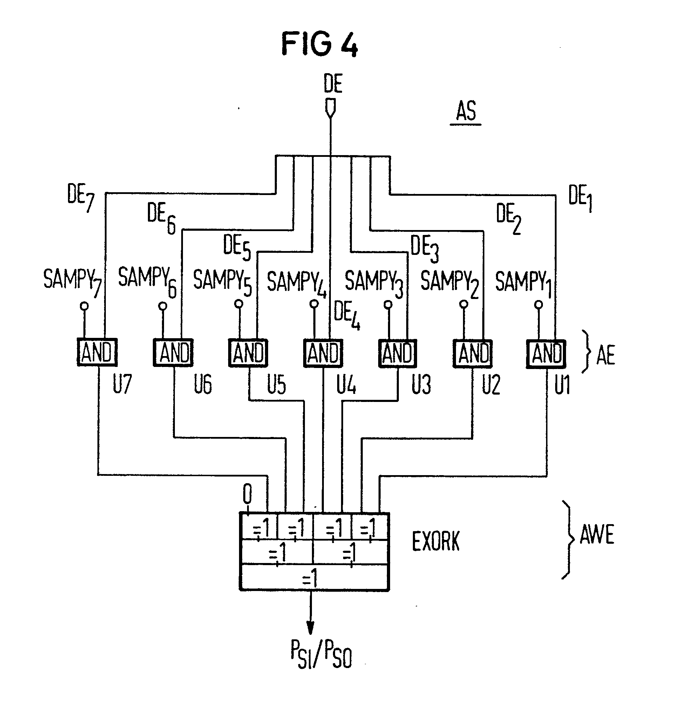

FIG 4 zeigt das Schaltbild der in FIG 2 und FIG 3 verwendeten Auswahlschaltung AS. Es läßt sich in eine Auswahleinrichtung AE und in eine Auswerteeinrichtung AWE unterteilen. Die Auswahleinrichtung AE weist gemäß dem Ausführungsbeispiel sieben UND-Glieder U1 bis U7 mit jeweils zwei Eingängen auf, die jeweils über einen ihrer Eingänge mit einem der aus dem Steuersignal SAMPY hervorgehenden Steuersignale $SAMPY_{7 bis 1}$ durchlässig geschaltet werden können. An den jeweils zweiten Eingängen liegt eines der Datensignale $DE_{7 bis 1}$ der Dateneinheit DE an. Die Indizes der Datensignale $DE_{7 bis 1}$ geben die Bitpositionen innerhalb der Dateneinheit DE und die der Steuersignale $SAMPY_{7 bis 1}$ die Anzahl der nach rechts auszuführenden Schiebeschritte an. Die erste Bitposition der Dateneinheit DE befindet sich demnach an der rechten Dateneinheitsgrenze. Die letzte, für das Ausführungsbeispiel also die achte, Bitposition kann unberücksichtigt bleiben, weil bei der Verschiebung um jeweils nur die restlichen Bitstellen diese Bitposition nie aus der Dateneinheit DE herausgeschoben wird und deshalb keinen Beitrag zur Paritätsbitbildung der aus der Dateneinheit DE herausgeschobenen Datenbits leistet.

Durch entsprechende Ansteuerung der UND-Schaltglieder U1 bis U7 mit den Steuersignalen $SAMPY_{7 bis 1}$ werden bestimmte Bitpositionen der Dateneinheit DE ausgewählt und an die nachfolgende Auswerteeinrichtung AWE weitergegeben. Die Ansteuerung der Auswahleinrichtung AE erfolgt ab der Durchführung wenigstens eines Schiebeschrittes in der Weise, daß jeweils beim ersten Steuersignal $SAMPY_1$ angefangen alle nachfolgenden Steuersignale bis einschließlich dem Steuersignal, dessen Index die Anzahl der restlichen Schiebeschritte angibt, aktiv werden. Die danach an die Auswerteeinrichtung AWE gelangenden Datensignale werden jeweils paarweise durch eine Kombination EXORK aus EXKLUSIV-ODER-Gliedern zu einem einzigen Ausgangssignal $P_{SI}/P_{SO}$ zusammengefaßt. Der dabei freibleibende Eingang eines EXKLUSIV-ODER-Gliedes bei der Zusammenfassung aller Datensignale DE $_{7 \text{ bis } 1}$ wird mit einem konstanten Pegel, z.B. logisch "O", belegt.

Bei dem Ausgangssignal P $_{SI}$/P $_{SO}$ handelt es sich um das Paritätsbit P $_{SI}$ der in eine Dateneinheit DE hineingeschobenen Datenbits, wenn der Auswahleinrichtung AE die Datensignale DE $_{7 \text{ bis } 1}$ der Vorgängerdateneinheit zugeführt werden, und um das Paritätsbit P $_{SO}$ der in eine Dateneinheit herausgeschobenen Datenbits, wenn der Auswahleinrichtung AE die Datensignale DE $_{7 \text{ bis } 1}$ dieser Dateneinheit zugeführt werden.

IN FIG 2 ist es, bezogen auf das Ausführungsbeispiel, nicht notwendig, die alten Paritätsbits P $_{alt}$ jeweils über ein eigenes EXKLUSIV-ODER-Glied, zum Beispiel EXOR 32, mit dem Verknüpfungsergebnis der Paritätsbits P $_{SI}$ und P $_{SO}$ zu verknüpfen. Die Paritätsbits P $_{alt}$ können jeweils in einer der Auswahlschaltungen AS über den freien, mit dem logischen Pegel "O" belegten Eingang eines der EXKLUSIV-ODER-Glieder einbezogen werden. Die in FIG 2 dafür vorgesehenen EXKLUSIV-ODER-Glieder EXOR 32, EXOR 22, EXOR 12 und EXOR 02 können dann entfallen. Damit ist die Schaltungsanordnung nach FIG 2 laufzeitoptimiert, während die Schaltungsanordnung nach FIG 3 aufwandsoptimiert ist.

Die um ganze Dateneinheiten verschiebende Datenverschiebeeinrichtung VE1 muß nicht notwendigerweise am Anfang der Datenverschiebung eingesetzt werden. Es ist möglich, die Dateneinheiten zuerst um die restlichen Bitstellen und nachfolgend um ganze Dateneinheiten zu verschieben.

Bei Verwendung von schnellen, mit Multiplexern aufgebauten Verschiebeeinrichtungen VE1 und VE2 ist die Gesamtanordnung nach FIG 1 besonders vorteilhaft.

Zyklische Linksverschiebungen können in gleicher Weise durch zyklische Rechtsverschiebungen mit entsprechend umgerechneten Schiebeamplituden durchgeführt werden. Bei nichtzyklischen Linksverschiebungen gelten die Bedingungen für nichtzyklisches Rechtsverschieben mit dem Zusatz, daß zwischen dem Datenbit DE1 und dem Datenbit DE8 umzuschalten ist und die Steuersignale entsprechend, statt von Bitposition 1 aufwärts von Bitposition 8 abwärts, zu betreiben sind. Außerdem muß die Ableitungsrichtung zur Gewinnung der Paritätsbits P$_{SI}$ umgeschaltet werden. Z.B. muß in FIG 3 P1$_{SI}$ nicht von P2$_{SO}$, sondern von PO$_{SO}$ übernommen werden.

Durch eine am Schluß der Übertragungsstrecke durchgeführte Paritätsbitkontrolle der einzelnen Dateneinheiten wird die Datenübertragung auf der gesamten Datenübertragungsstrecke, einschließlich der Datenschiebeeinrichtungen, überwacht.

**Patentansprüche**

1. Verfahren zur Paritätsbitermittlung bei der Übertragung von binären Daten in Datenverarbeitungsanlagen, wobei die Daten jeweils aus einer Gruppe von Dateneinheiten von je n Datenbits und je einem Paritätsbit bestehen und alle Datenbits der zu übertragenden Daten während der Übertragung um eine vorgegebene Anzahl von Bitstellen wenigstens einmal in die eine oder andere Richtung verschoben und mit jeder Verschiebung neue Daten gleichen Aufbaus gebildet werden, **dadurch gekennzeichnet,** daß parallel zu einem auf weniger als n Bitstellen beschränkten Schiebevorgang abhängig von der Schiebeamplitude (SAMP) je Dateneinheit das Paritätsbit (P $_{SI}$) der in diese Dateneinheit zu übernehmenden Datenbits und das Paritätsbit (P $_{SO}$) der von dieser Dateneinheit abzugebenden Datenbits ermittelt wird und daß das sich aus der Verschiebung ergebende neue Paritätsbit (P $_{neu}$) der veränderten Dateneinheit aus dem ursprünglichen Paritätsbit (P $_{alt}$) und den beiden neu ermittelten Paritätsbits (P $_{SI}$ und P $_{SO}$) durch EXKLUSIV-ODER-Glieder nach der Beziehung

$$P_{neu} = P_{alt} \# P_{SI} \# P_{SO}$$

ermittelt und den durch die Schiebeeinrichtung für die zugehörige Dateneinheit gelieferten Datenbits als Paritätsbit zugesetzt wird.

2. Verfahren nach Anspruch 1, **dadurch gekennzeichnet,** daß bei n oder mehr Bitstellen umfassenden Verschiebungen notwendig werdende Verschiebungen um ganze Dateneinheiten vor bzw. nach der Verschiebung um die restlichen Datenbitstellen mit Ermittlung der neuen Paritätsbits ausgeführt werden.

3. Verfahren nach Anspruch 1 oder 2, **dadurch gekennzeichnet,** daß im Falle einer nicht zyklischen Verschiebung die infolge der Verschiebung von den ursprünglichen Datenbits geräumten Bitstellen durch Datenbits mit einem konstanten Wert (z.B. "O") aufgefüllt werden und daß bei vollständig geräumten Dateneinheiten ein entsprechendes Paritätsbit eingesetzt wird.

4. Verfahren nach einem der Ansprüche 1 bis 3, **dadurch gekennzeichnet,** daß zur Paritätsbitermittlung für m Dateneinheiten bei wenigstens m-1 Dateneinheiten neben dem ursprünglichen Paritätsbit (P $_{alt}$) einer Dateneinheit entweder nur das Pritätsbit (P $_{SI}$) der in diese Dateneinheit hineingeschobenen Datenbits oder nur das Paritätsbit (P $_{SO}$) der aus dieser Dateneinheit herausgeschobenen Datenbits ermittelt wird und daß zur Berechnung des jeweiligen neuen Paritätsbits (P neu) anstelle des fehlenden Paritätsbits (z.B. P SO) das ermittelte entsprechende Paritätsbit (z.B. P SI) der benachbarten Dateneinheit verwendet wird.

5. Verfahren zur Überwachung der Übertragung von während der Übertragung Verschiebungen unterworfenen Daten mit Paritätsbitermittlung je Schiebevorgang entsprechend dem Verfahren nach einem der Ansprüche 1 bis 4, **dadurch gekennzeichnet,** daß während der gesamten Übertragung die von den Daten mitgeführten Paritätsbits lediglich einmal am Ende der Übertragung überprüft werden, indem aus den Datenbits jeder Dateneinheit das Paritätsbit neu ermittelt und mit dem mitgeführten Paritätsbit verglichen wird.

6. Schaltungsanordnung zur Durchführung des Verfahrens nach einem der Ansprüche 1 bis 5, **dadurch gekennzeichnet,** daß die Schaltungsanordnung (SA) zur Ermittlung der jeweils neuen Paritätsbits (P neu) für die einzelnen Dateneinheiten (DE) an den Eingang der Verschiebeeinrichtung (VE2) parallel zu dieser angekoppelt ist und je Dateneinheit (DE) zwei Auswahleinrichtungen (AE) für maximal je n-1 Datenbits aufweist, von denen die eine jeweils abhängig von der das Ausmaß der Verschiebung festlegenden Schiebeamplitude (SAMP) aus der zugehörigen Dateneinheit herauszuschiebende Datenbits und die andere von der in Schieberichtung vorangehenden Dateneinheit die in die zugehörige Dateneinheit hineinzuschiebende Datenbits gleichzeitig auswählt, und daß die jeweils ausgewählten Datenbits in einer aus EXKLUSIV-ODER-Gliedern bestehenden Auswerteeinrichtung (AWE) zur Ermittlung des Paritätsbits (P SO) der abzugebenden Datenbits und des Paritätsbits (P SI) für die aufzunehmenden Datenbits zusammengefaßt werden, die dann über weitere EXKLUSIV-ODER Glieder zusammen mit dem zugehörigen ursprünglichen Paritätsbit (P alt) das neue Paritätsbit (P neu) der durch die Verschiebung neu gebildeten Dateneinheit bilden.

7. Schaltungsanordnung nach Anspruch 6, **dadurch gekennzeichnet,** daß je Dateneinheit (DE) lediglich eine Auswahleinrichtung (AE) mit nachgeschalteten EXKLUSIV-ODER-Gliedern zur Bildung des Paritätsbits (P SI bzw. P SO) für die von einer Dateneinheit (DE) aufzunehmenden bzw. abzugebenden Datenbits vorgesehen ist, und daß das hierdurch gebildete Paritätsbit (P SI bzw. P SO) an die Auswerteeinrichtung (AWE) in Schieberichtung folgende bzw. vorangehende Dateneinheit weitergeleitet wird.

8. Schaltungsanordnung nach Anspruch 6 oder 7, **dadurch gekennzeichnet,** daß bei n oder mehr Bitstellen umfassenden Verschiebungen der Dateneinheiten (DE) der um die restlichen Bitstellen mit Ermittlung der neuen Paritätsbits (P neu) verschiebenden Verschiebeeinrichtung (VE2) eine Verschiebeeinrichtung (VE1) zur notwendigen Verschiebung um ganze Dateneinheiten vor bzw. nachgeschaltet ist.

## Claims

1. Method for calculating the parity bit during the transmission of binary data in data processing systems, the data being composed in each case of a group of data units of n data bits each and one parity bit each, and all data bits of the data to be transmitted being shifted during the transmission by a predetermined number of bit positions at least once in the one or other direction and new data having the same structure being formed with each shift, characterised in that, parallel to a shift operation limited to less than n bit positions and depending on the shift amplitude (SAMP) per data unit, the parity bit ($P_{SI}$) of the data bits to be transferred into this data unit and the parity bit ($P_{SO}$) of the data bits to be output by this data unit are calculated, and in that the new parity bit ($P_{neu}$) of the altered data unit resulting from the shift is calculated from the original parity bit ($P_{alt}$) and the two newly calculated parity bits ($P_{SI}$ and $P_{SO}$) using EXCLUSIVE-OR elements in accordance with the relationship

$$P_{neu} = P_{alt} \# P_{SI} \# P_{SO}$$

and is added as a parity bit to the data bits supplied by the shifting device for the associated data unit.

2. Method according to Claim 1, characterised in that, given shifts comprising n or more bit positions, shifts by whole data units which become necessary are executed before or after the shift by the remaining data bit positions, with calculation of the new parity bit.

3. Method according to Claim 1 or 2, characterised in that, in the event of a non-cyclical shift, the bit positions vacated by the original data bits as a result of the shift are padded by data bits having a constant value (e.g. "0"), and in that a corresponding parity bit is inserted in completely vacated data units.

4. Method according to one of Claims 1 to 3, characterised in that, for calculating the parity bit for m data units, given at least m-1 data units, in addition to the original parity bit ($P_{alt}$) of a data unit, either only the parity bit ($P_{SI}$) of the data bit pushed into this data unit or only the parity bit ($P_{SO}$) of the data bit pushed out of this data unit is calculated, and in that, for calculating the respective new parity bit ($P_{neu}$), instead of the missing parity bit (e.g. $P_{SO}$) the calculated corresponding parity bit (e.g. $P_{SI}$) of the adjacent data unit is employed.

5. Method for monitoring the transmission of data subjected to shifting during transmission with parity bit calculation per shift operation in accordance with the method according to one of Claims 1 to 4, characterised in that during the entire transmission the parity bits carried by the data are checked only once at the end of the transmission in that the parity bit is newly calculated from the data bits of each data unit and is compared with the carried parity bit.

6. Circuit arrangement for carrying out the method according to one of Claims 1 to 5, characterised in that the circuit arrangement (SA) for calculating the respective new parity bits ($P_{neu}$) for the individual data units (DE) is connected to the input of the shifting device (VE2), parallel to the latter, and has for each data unit (DE) two selection devices (AE) for a maximum of n-1 data bits each, one of which selects, in each case depending on the shift amplitude (SAMP) defining the extent of the shift, data bits to be pushed out of the associated data unit, and the other of which simultaneously selects the data bits to be pushed into the associated data unit from the preceding data unit seen in the shift direction, and in that the respective selected data bits are combined in an evaluation device (AWE) composed of EXCLUSIVE-OR elements to calculate the parity bit ($P_{SO}$) of the data bits to be output and the parity bit ($P_{SI}$) for the data bits to be received, which then form, via further EXCLUSIVE-OR elements together with the associated original parity bit ($P_{alt}$), the new parity bit ($P_{neu}$) of the data unit newly formed by the shift.

7. Circuit arrangement according to initial Claim 6, characterised in that for each data unit (DE) only one selection device (AE) with downstream EXCLUSIVE-OR elements for forming the parity bit ($P_{SI}$ or $P_{SO}$) for the data bits to be received or output by a data unit (DE), respectively, is provided, and in that the parity bit ($P_{SI}$

or $P_{SO}$) thus formed is forwarded to the data unit following or preceding the evaluation device (AWE) seen in the shift direction.

8. Circuit arrangement according to Claims 6 or 7, characterised in that, given data unit (DE) shifts comprising n or more bit positions, a shifting device (VE1) for the necessary shifting by whole data units is connected upstream or downstream of the shifting device (VE2) which shifts by the remaining bit positions with calculation of the new parity bits ($P_{neu}$).

**Revendications**

1. Procédé pour déterminer le bit de parité lors du contrôle de données binaires dans des installations de traitement de données, selon lequel les données sont constituées respectivement par un groupe d'unités de données comprenant respectivement n bits de données, et respectivement un bit de parité, et tous les bits des données devant être transmises sont décalés au moins une fois dans un sens ou dans l'autre, d'un nombre prédéterminé de positions binaires, pendant la transmission, et de nouvelles données ayant une constitution identique sont formées lors de chaque décalage, caractérisé par le fait qu'en parallèle avec un processus de décalage limité a moins de n positions binaires, le bit de parité ($P_{SI}$), en fonction de l'amplitude (SAMP) de décalage pour chaque unité de données, le bit de parité ($P_{SI}$) des bits de données devant être pris en charge par l'unité de données et le bit de parité ($P_{SO}$) des bits de données devant être délivrés par cette unité de données sont déterminés et que le nouveau bit de parité ($P_{nouveau}$), qui résulte du décalage, de l'unité de données modifiée est déterminé à partir du bit de parité d'origine ($P_{ancien}$) et à partir des deux bits de parité ($P_{SI}$ et $P_{SO}$) nouvellement déterminés, au moyen de circuits OU-EXCLUSIF conformément à la relation

$$P_{nouveau} = P_{ancien} \# P_{SI} \# P_{SO}$$

et est ajouté, en tant que bit de parité, aux bits de données délivrés par le dispositif de décalage pour l'unité associée de données.

2. Procédé suivant la revendication 1, caractérisé par le fait que dans le cas de décalages s'étendant sur n positions binaires ou plus, des décalages, qui deviennent nécessaires, sont exécutés sur des unités entières de données avant ou après le décalage exécuté sur les positions binaires restantes de données, avec la détermination des nouveaux bits de parité.

3. Procédé suivant la revendication 1 ou 2, caractérisé par le fait que, dans le cas d'un décalage non cyclique, les positions binaires éliminées en raison du décalage des bits initiaux de données, sont complétés par des bits de données ayant une valeur constante (par exemple "0") et qu'un bit de parité correspondant est utilisé dans des unités de données complètement éliminées.

4. Procédé suivant l'une des revendications 1 à 3, caractérisé par le fait que, pour la détermination du bit de parité pour la m unité de données, dans le cas d'au moins m-1 unités de données, on détermine, en dehors du bit initial de parité $P_{ancien}$ d'une unité de données, soit uniquement le bit de parité ($P_{SI}$) des bits de données insérés par décalage dans cette unité de données, soit seulement le bit de parité ($P_{SO}$) des bits de données extraits de cette unité de données, par décalage, et que pour le calcul du nouveau bit respectif de parité ($P_{nouveau}$), on utilise, à la place du bit de parité manquant (par exemple $P_{SO}$), le bit de parité correspondant déterminé (par exemple $P_{SI}$) de l'unité de données voisines.

5. Procédé pour contrôler la transmission de données soumises à des décalages pendant la transmission, avec une détermination des bits de parité en fonction de l'opération de décalage, conformément au procédé selon l'une des revendications 1 à 4, caractérisé en ce que, pendant l'ensemble de la transmission, les bits de parité transférés conjointement avec les données sont contrôlés seulement une fois à la fin de la transmission, par le fait que le bit de parité est à nouveau déterminé à partir des bits de données de chaque unité de données et est comparé au bit de parité transmis conjointement.

6. Montage pour la mise en oeuvre du procédé suivant l'une des revendications 1 à 5, caractérisé par le fait que le montage (SA) est accouplé en parallèle à l'entrée du dispositif de décalage (VE2) pour la détermination des nouveaux bits respectifs de parité ($P_{nouveau}$) pour les différentes unités de données (DE) et que chaque unité de données (DE) comporte deux dispositifs de sélection (AE) pour un maximum de n-1 bits de données, l'un de ces dispositifs sélectionnant des bits de données devant être extraits, par décalage, à partir de l'unité de données associée, respectivement en fonction de l'amplitude de décalage (SAMP) déterminant la valeur du décalage, tandis que l'autre sélectionne simultanément, dans l'unité de données précédente dans la direction de décalage, les bits de données devant être inséré par décalage dans l'unité de données associée, et que les bits de données respectivement sélectionnés sont réunis, dans un dispositif d'évaluation (AWE) constitué par des circuits OU-EXCLUSIF pour la détermination du bit de parité ($P_{SO}$) du bit de données devant être délivré et du bit de parité ($P_{SI}$) pour les bits de données devant être reçus et qui forment alors, par l'intermédiaire d'autres circuits OU-EXCLUSIF, conjointement avec le bit initial de parité associé ($P_{ancien}$), le nouveau bit de parité ($P_{nouveau}$) de l'unité de données nouvellement formée par le décalage.

7. Montage suivant la revendication 6, caractérisé par le fait que, pour chaque unité de données (DE), il n'est prévu qu'un seul dispositif de sélection (AE), en aval duquel sont branchés des circuits OU-EXCLUSIF pour la formation du bit de parité ($P_{SI}$ ou $P_{SO}$) pour les bits de données devant être reçus ou délivrés par l'unité de données (DE), et que le bit de parité ($P_{SI}$ ou $P_{SO}$) formé de ce fait est envoyé à l'unité de données qui suit ou précède le dispositif d'évaluation (AWE) dans le sens du décalage.

8. Montage suivant la revendication 7, caractérisé par le fait que des décalages, portant sur n positions binaires ou plus, des unités de données (DE), un dispositif de décalage (VE1) servant à réaliser le décalage nécessaire sur des unités complètes de données est branché en amont ou en aval du dispositif de décalage (VE2) réalisant un décalage sur les positions binaires restantes lors de la détermination du nouveau bit de parité ($P_{nouveau}$).

# FIG 1

# FIG 2

# FIG 3

# FIG 4